Europäisches Patentamt

European Patent Office

Office européen des brevets

(11) Numéro de publication: **0 296 005 B1**

# FASCICULE DE BREVET EUROPEEN

(45) Date de publication de fascicule du brevet: **28.10.92**     (51) Int. Cl.⁵: **G01R 33/24**

(21) Numéro de dépôt: **88401335.0**

(22) Date de dépôt: **02.06.88**

(54) **Magnétomètre à résonance magnétique nucléaire.**

(30) Priorité: **11.06.87 FR 8708172**

(43) Date de publication de la demande:
**21.12.88 Bulletin 88/51**

(45) Mention de la délivrance du brevet:
**28.10.92 Bulletin 92/44**

(84) Etats contractants désignés:
**DE ES FR GB IT NL**

(56) Documents cités:
**EP-A- 0 206 931
GB-A- 1 009 858
US-A- 3 145 336
US-A- 3 239 752**

**INSTRUMENTS AND EXPERIMENTAL TECHNI-OUES, vol. 18, no. 4, partie 2, 8 juillet 1975, pages 1306-1308, New York, US; V.I. KURAS-HOV et al.: "A follow-up magnetometer ba-sed on an E11-2 magnetic field meter"**

(73) Titulaire: **SEXTANT Avionique
5/7 rue Jeanne Braconnier Parc Tertiaire
F-92368 MEUDON LA FORET Cédex(FR)**

(72) Inventeur: **Verdier, Robert
à
F-26300 Barbières(FR)**

(74) Mandataire: **Bloch, Gérard et al
2, square de l'Avenue du Bois
F-75116 Paris(FR)**

## Description

La présente invention a pour objet un magnétomètre à résonance magnétique nucléaire comprenant deux demi-bobines de prélèvement et de réinjection de signaux de précession des spins nucléaires de deux échantillons d'un matériau ayant des propriétés gyromagnétiques, disposés dans le champ magnétique à mesurer et excités par un générateur VHF, un condensateur connecté aux bornes des deux demi-bobines, un amplificateur différentiel connecté aux bornes du condensateur, un déphaseur connecté à la sortie de l'amplificateur différentiel, des moyens pour réinjecter dans chaque demi-bobine un courant commandé par le signal en sortie du déphaseur, et un fréquencemètre pour mesurer la fréquence des oscillations de l'oscillateur ainsi formé, fréquence proportionnelle au champ magnétique à mesurer.

De tels magnétomètres sont décrits dans les brevets français N° 1 447 226 du 20 Avril 1965 et 2 098 624 du 14 Février 1972, notamment en ce qui concerne la technique à double effet permettant grâce à un choix judicieux des matériaux d'obtenir des polarisations inversées pour chaque échantillon pour une même fréquence d'excitation de raie électronique.

Mais ce type de magnétomètre présente des inconvénients.

D'une part, la sélectivité naturelle du circuit résonant comprenant les demi-bobines et le condensateur limite la plage d'exploration du magnétomètre qui ne peut s'étendre sur tout le domaine du champ magnétique terrestre.

Le document GB-A-1 009 858 suggère de pallier cet inconvénient en remplaçant la condensateur par une batterie de condensateurs en parallèle. Toutefois la commutation de ces condensateurs se fait manuellement et non par des moyens électroniques.

D'autre part, lorsque la fréquence de Larmor s'écarte de la fréquence d'accord du circuit oscillant, des déphasages parasites entre les signaux prélevés et les signaux réinjectés sont introduits, qui ont pour conséquence en entraînement de la fréquence de l'oscillateur, c'est-à-dire que celle-ci n'est plus rigoureusement égale à la fréquence de Larmor. Il en résulte une erreur de mesure.

Enfin, un tel magnétomètre est sensible aux vériations de température, et aux variations d'attitude des échantillons relativement au champ magnétique à mesurer.

La présente invention vise à pallier ces inconvénients en procurant un magnétomètre du type défini ci-dessus, qui permet, sur tout le domaine du champ magnétique terrestre, des mesures plus précises que les magnétomètres de l'art antérieur.

A cet effet, elle a pour objet un magnétomètre du type défini ci-dessus, caractérisé par le fait que le déphaseur est agencé pour introduire un déphasage constant et égal à 90° sur tout le domaine de fréquence des oscillations, le condensateur fait partie d'une batterie de condensateurs, et il est prévu des moyens pour, en réponse à la valeur de la fréquence mesurée par le fréquencemètre, commander la commutation des condensateurs de la batterie, de façon à ce que les déphasages parasites entre les signaux prélevés et les signaux réinjectés dans les deux demi-bobines restent toujours inférieurs à un seuil.

Dans le magnétomètre de l'invention, du fait que le déphaseur n'introduit aucun déphasage parasite, le déphasage parasite global est maintenu inférieur à un seuil compatible avec la précision souhaitée des mesures, en commutant les condensateurs de la batterie pour que la fréquence d'accord du circuit résonant reste en permanence voisine de la fréquence de Larmor. La plage à l'intérieur de laquelle les mesures sont précises est donc beaucoup plus étendue que dans le magnétomètre de l'art antérieur.

Avantageusement, il est prévu, en sortie du déphaseur, un amplificateur à gain commandable, relié à un capteur de température, pour faire varier le niveau des signaux réinjectés en fonction de la température.

Ainsi, il est tenu compte de l'influence de la température, et la précision des mesures effectuées est indépendante de la température.

Avantageusement encore, il est prévu un capteur pour déterminer l'attitude des échantillons par rapport au champ magnétique à mesurer, et un amplifcateur à gain commandable en sortie du déphaseur, commandé par ledit capteur d'attitude, et le générateur VHF est de puissance commandable, commandée par ledit capteur d'attitude.

Ainsi, il est tenu compte de l'influence de l'orientation des échantillons, relativement au champ magnétique à mesurer, et la précision des mesures effectuées est indépendante de cette orientation.

La présente invention sera mieux comprise à la lecture de la description suivante de la forme de réalisation préférée du magnétomètre de l'invention, faite en se référant aux dessins annexés, sur lesquels

- la figure 1 représente un magnétomètre de l'art antérieur,
- la figure 2 représente un magnétomètre selon l'invention.

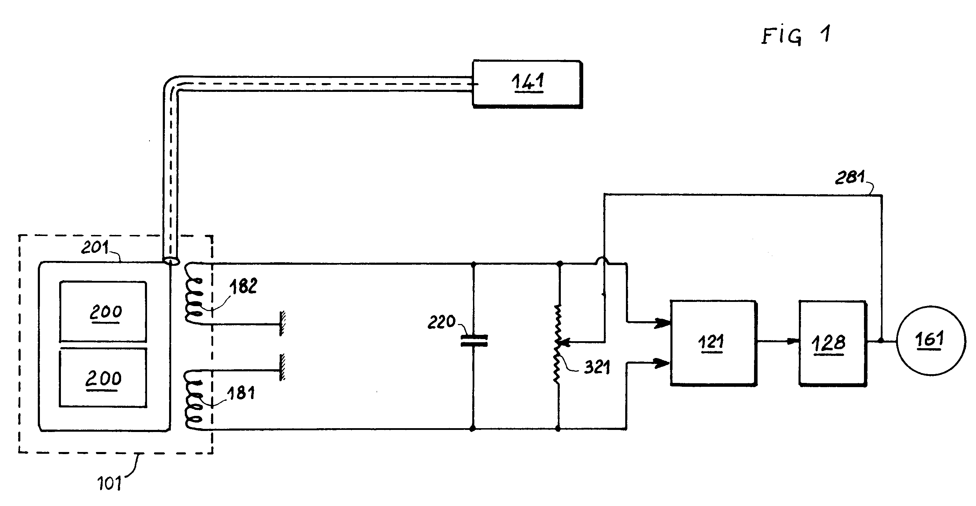

En se référant à la figure 1, un magnétomètre comprend une sonde de mesure 101 placée dans le champ magnétique à mesurer.

La sonde de mesure 101 comprend deux demi-bobines 181 et 182, enroulées concentriquement, de façon non représentée car connue, autour de deux échantillons 200 d'un matériau ayant des propriétés gyromagnétiques, en l'occurence un solvant comprenant des noyaux atomiques à moment magnétique non nul, et une substance paramagnétique en solution stable (radical libre comportant un électron célibataire en interaction avec un noyau atomique de la substance).

Ces échantillons 200 sont entourés d'une cavité résonante 201, assurant une polarisation dynamique des noyaux du matériau, et alimentée par un générateur VHF 141, de très haute fréquence et de puissance fixes, destiné à exciter des raies de résonance électronique des échantillons 200.

Les deux demi-bobines 181 et 182 assurent le prélèvement et la réinjection de signaux de précession des spins nucléaires, en vue de l'entretien d'oscillations à la fréquence de Larmor. Chaque demi-bobine 181 et 182 a une extrémité reliée à la masse, l'autre extrémité étant reliée à une des armatures d'un condensateur 220. Le condensateur 220 et les deux demi-bobines 181 et 182 forment un circuit résonant dans lequel une force électromotrice est induite par les spins à la fréquence de Larmor, et amplifiée par la sélectivité de ce circuit.

Un amplificateur différentiel 121 amplifie le signal aux bornes du condensateur 220. Il est suivi par un déphaseur 128, de type LC, qui déphase de 90° le signal en sortie de l'amplificateur 121 lorsque celui-ci est à la fréquence d'accord du circuit résonant. Le signal de sortie du déphaseur 128 est rebouclé, par une ligne 281, sur le curseur d'un potentiomètre 321 dont la résistance est montée en parallèle sur le condensateur 220, pour réinjecter des courants symétriques dans chaque demi-bobine 181 et 182. L'entretien des oscillations de l'oscillateur ainsi formé est alors assuré.

Un fréquencemètre 161 de mesure de la fréquence des oscillations permet de connaître la valeur de cette fréquence, et d'en déduire la valeur du champ magnétique à mesurer, proportionnel à cette fréquence.

Un tel magnétomètre a pour inconvénient une plage de mesure limitée, du fait que, lorsque le circuit oscillant et le déphaseur LC ne sont pas accordés rigoureusement sur la fréquence de Larmor à mesurer, des déphasages parasites sont introduits entre la force électomotrice induite dans les demi-bobines 181 et 182 et le courant réinjecté par le potentiomètre 321, ce qui a pour conséquence un entraînement de la fréquence, c'est-à-dire que la fréquence des oscillations mesurée par l'appareil 161 diffère de la fréquence de Larmor.

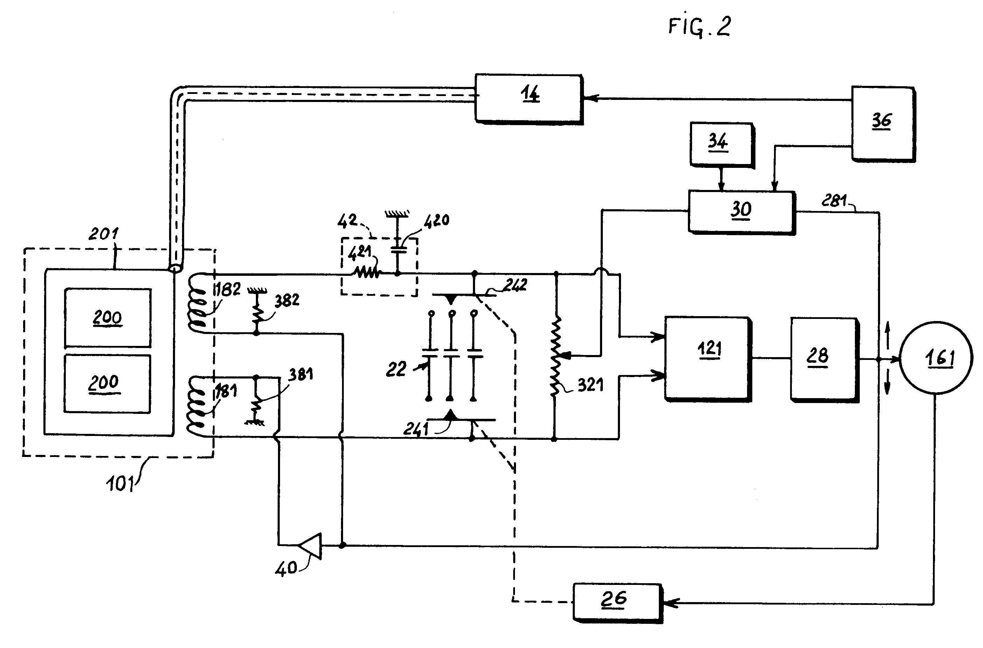

En référence maintenant à la figure 2, le magnétomètre de l'invention comprend une sonde 101 comprenant une cavité 201, deux échantillons 200 et deux demi-bobines 181 et 182 identiques à ceux de la figure 1.

La cavité 201 est excitée par un générateur VHF 14, comparable au générateur VHF 141 de la figure 1, mais sont la puissance est commandable, comme cela sera mieux compris dans la suite.

Chaque demi-bobine 181 et 182 a une première extrémité reliée à la masse par l'intermédiaire d'une résistance de très faible valeur 381 et 382, respectivement. La deuxième extrémité de la bobine 181 est reliée au contact mobile d'un commutateur 241 à plusieurs positions. La deuxième extrémité de la bobine 182 est reliée au contact mobile d'un commutateur 242 à plusieurs positions, par l'intermédiaire d'une cellule de correction 42 dont le rôle sera mieux compris dans la suite.

Les deux commutateurs 241 et 242 sont accouplés, et commandés simultanément par un circuit de commande 26 pour pouvoir commander la connexion, entre les deux deuxièmes extrémités des demi-bobines 181 et 182, de l'un quelconque des condensateurs d'une batterie 22 de condensateurs, disposée entre les contacts fixes des commutateurs 241 et 242. Par "batterie" de condensateur, on entend ici une pluralité, ou encore une série, de condensateurs.

Un amplificateur différentiel 121, analogue à celui de la figure 1, amplifie le signal aux bornes du condensateur de la batterie 22 qui se trouve en service. Il est suivi par un déphaseur 28, ici du type actif asservi, assurant un déphasage de 90° constant à ± 1° quelle que soit la fréquence. Le signal de sortie du déphaseur 28 est rebouclé, par l'intermédiaire d'une ligne 281 et d'un amplificateur 30 à gain commandable, sur le curseur d'un potentiomètre 321 dont la résistance est montée en parallèle sur le condensateur de la batterie 22 qui se trouve en service. La ligne 281 et le potentiomètre 321 sont analogues à ceux de la figure 1.

Un fréquencemètre 161 de la mesure de la fréquence des oscillations, analogue à celui de la figure 1, permet de connaître la valeur de cette fréquence, pour en déduire la valeur du champ magnétique à mesurer. Il délivre au circuit de commande 26 un signal représentatif de la valeur de la fréquence mesurée.

Un capteur 34, de mesure de la température, commande le gain de l'amplificateur 30, d'une façon qui sera mieux comprise dans la suite.

Un capteur 36, de détermination de la position de la sonde de mesure 101 par rapport au champ magnétique à mesurer, commande d'une part le gain de l'amplificateur 30, et d'autre part la puissance du générateur VHF 14.

Le signal de sortie du déphaseur 28 est appliqué directement au point de jonction entre la demi-bobine 182 et la résistance 382, et, par l'intermédiaire d'un inverseur 40 de gain unitaire, au point de jonction entre la demi-bobine 181 et la résistance 381.

Le magnétomètre de la figure 2, dont la structure vient d'être décrite, fonctionne comme suit.

Le circuit de commande 26 est ici un calculateur, agencé pour, en réponse à la valeur de la fréquence mesurée par le fréquencemètre 161, commander la connexion d'un des condensateurs de la batterie 22. A cet effet, le domaine total de fréquences d'oscillation à mesurer, qui, de façon typique, s'étend de 1000 à 3000 $H_z$ est divisé en un certain nombre de gammes jointives, chaque gamme correspondant à un condensateur déterminé de la batterie 12. Ainsi, la gamme de rang n est centrée sur la fréquence central $F_n$, et s'étend de la fréquence minimale $F_{n-1,n}$ à la fréquence maximale $F_{n,n+1}$. A cette gamme est affecté un condensateur $C_n$ de la batterie 12, dont la valeur est déterminée pour que le circuit résonant formé par le condensateur $C_n$ et les deux demi-bobines 181 et 182 soit accordésur la fréquence $F_n$.

Le circuit de commande 26 est donc agencé pour déterminer dans quelle gamme se trouve la fréquence F mesurée par le fréquencemètre 161, et commander la connexion du condensateur de la batterie 12 affecté à cette gamme.

Le découpage du domaine total en gammes est effectué pour respecter le critère suivant. Dans chaque gamme, lorsque la fréquence diffère de la fréquence central $F_n$, il est introduit des déphasages parasites, notamment du fait que le circuit résonant ne travaille pas sur sa fréquence d'accord. On peut déterminer l'importance de ces déphasages parasites en mesurant le déphasage parasite total apparaissant, en boucle ouverte, entre la force électromotrice induite dans les demi-bobines 181 et 182 et la tension en sortie du déphaseur 28, c'est-à-dire entre les signaux prélevés et les signaux réinjectés par les demi-bobines 181 et 182. Le découpage en gammes est fait pour que, à l'intérieur de chaque gamme, le déphasage parasite, mesuré en boucle ouverte, reste inférieur à un seuil. Ici, et par exemple, le seuil est de 20°. D'une manière générale, il est souhaitable que ce seuil reste inférieur à environ 30°.

On notera que le déphasage introduit par le déphaseur 28 restant en pratique, toujours égal à 90°, ce déphaseur n'introduit aucun déphasage parasite.

Naturellement, il n'est pas absolument nécessaire de disposer d'autant de condensateurs dans la batterie 12 que de gammes, la mise en parallèle judicieuse de certains d'entre eux permettant de couvrir un domaine large avec un nombre minimum de condensateurs.

Le circuit de commande 26 est agencé pour assurer une commutation d'une gamme jointive à l'autre le long du domaine de mesure, en mode poursuite, ainsi qu'une présélection au démarrage, en mode initialisation du magnétomètre.

Le niveau du signal de réinjection, en sortie de l'amplificateur 30 à gain commandable est asservi à la température grâce à la sonde 34 qui commande la valeur du gain de l'amplificateur 30. La loi de variation du niveau, en fonction de la température, est telle qu'elle permet un niveau de réinjection compatible avec le signal recueilli par les bobines qui, lui, est fonction de la température. Par exemple, le niveau réinjecté à +60°C vaut sensiblement la moitié du niveau réinjecté à -40°C, la variation entre ces deux température extrêmes étant sensiblement linéaire.

De même, le niveau de réinjection, en sortie de l'amplificateur 30 à gain commandable est aussi asservi à la position de la sonde de mesure 101 par rapport au champ magnétique à mesurer, grâce au capteur 36. Cette correction permet de rendre optimal le niveau de réinjection vis à vis du signal utile, recueilli par les bobinages 181 et 182.

Le capteur 36 est un magnétomètre triaxial du type "fluxgate", par exemple, qui permet notamment la détermination de l'angle $\alpha$ entre l'axe de symétrie de la sonde de mesure 101 et le champ magnétique à mesurer. Il commande le gain de l'amplificateur 30 afin que le niveau réinjecté lorsque l'angle $\alpha$ vaut ± 90° soit de 4 à 5 dB inférieur au niveau réinjecté lorsque l'angle $\alpha$ est nul.

De même, la puissance du générateur VHF 14, qui permet la polarisation des spins nucléaires, est commandée par le capteur 36, afin de compenser l'anisotropie de cette polarisation. Ainsi, le capteur 36 commande cette puissance afin que sa valeur, lorsque l'angle $\alpha$ vaut ± 90°, vaille sensiblement 0,7 fois sa valeur, lorsque l'angle $\alpha$ est nul.

Le signal de sortie du déphaseur 28 est utilisé pour établir une contre-réaction en courant dans le circuit des demi-bobines de mesure 181 et 182, grâce aux deux résistances 381 et 382 parcourues par des courants de contre-réaction en opposition de phase. La linéarisation apportée par cette contre réaction, tout en conservant le rapport signal sur bruit, autorise une marge de phase plus grande dans l'oscillateur et par là un meilleur étalement des gammes par l'intermédiaire du choix des condensateurs 22.

L'équilibrage des deux demi-bobines 181 et 182 est obtenu par fabrication, d'une part, et grâce à l'adjonction de la cellule de correction 42 disposée en série avec l'une des deux bobines, d'autre pat.

Cette cellule permet d'appairer les résistances des bobines grâce à une résistance 421 en série, d'une part, et d'appairer les capacités parasites par rapport à la masse grâce à un condensateur 420 en parallèle, d'autre part.

L'invention concerne plus particulièrement les magnétomètres à couplage de spin destinés à mesurer avec précision les champs magnétiques faibles tels que le champ magnétique terrestre dont la valeur varie de

$$\frac{50}{\pi} \text{ à } \frac{175}{\pi} \text{ A/m}$$

(0,2 à 0,7 oersted) et à détecter des variations de très faibles amplitudes de ces champs, de l'ordre de

$$\frac{10^{-4}}{4\,\pi} \text{ A/m}$$

($10^{-7}$ oersted) par exemple.

Naturellement, deux gammes jointives sont, en fait, en léger recouvrement et il est introduit de l'hystérésis de façon à éviter des commutations erratiques entre une gamme et la suivante, lorsque la fréquence des oscillations est à la frontière entre ces deux gammes.

## Revendications

1. Magnétomètre à résonance magnétique nucléaire comprenant deux demi-bobines (181,182) de prélèvement et de réinjection de signaux de précession des spins nucléaires de deux échantillons (200) d'un matériau ayant des propriétés gyromagnétiques, disposés dans le champ magnétique à mesurer et excités par un généerateur VHF (141), un condensateur (22) connecté aux bornes des deux demi-bobines (181,182), un amplificateur différentiel (121) connecté aux bornes du condensateur (22), un déphaseur (28) connecté à la sortie de l'amplificateur différentiel (121), des moyens (321) pour réinjecter dans chaque demi-bobine (181,182) un courant commandé par le signal en sortie du déphaseur (28), et un fréquencemètre (161) pour mesurer la fréquence des oscillations de l'oscillateur ainsi formé, fréquence proportionnelle au champ magnétique à mesurer, caractérisé par le fait que le déphaseur (28) est agencé pour introduire un déphasage constant et égal à 90° sur tout le domaine de fréquence des oscillations, le condensateur fait partie d'une batterie (22) de condensateurs, et il est prévu des moyens (26, 241, 242) pour, en réponse à la valeur de la fréquence mesurée par le fréquencemètre (161), commander la commutation des condensateurs de la batterie (22), de façon à ce que les déphasages parasites entre les signaux prélevés et les signaux réinjectés dans les deux demi-bobines (181,182) restent toujours inférieurs à un seuil.

2. Magnétomètre selon la revendication 1, dans lequel il est prévu, en sortie du déphaseur (28) un amplificateur (30) à gain commandable, relié à un capteur de température (34), pour faire varier le niveau des signaux réinjectés en fonction de la température.

3. Magnétomètre selon l'une des revendications 1 ou 2, dans lequel il est prévu un capteur (36) pour déterminer la position des échantillons (200) par rapport au champ magnétique à mesurer et un amplifcateur (30) à gain commandable en sortie du déphaseur (28), commandé par ledit capteur de position (36), et le générateur VHF (14) est de puissance commandable, commandée par ledit capteur (36).

## Claims

1. Nuclear magnetic resonance magnetometer comprising two semi-coils (181,182) for picking up and reinjecting signals of precession of the nuclear spins of two samples (200) of a material having gyromagnetic properties, disposed in the magnetic field to be measured and energized by a VHF generator (141), a capacitor (22) connected to the terminals of the two semi-coils (181,182), a differential amplifier (121) connected to the terminals of the capacitor (22), a phase shifter (28) connected to the output of the differential amplifier (121), means (321) for reinjecting into each semi-coil (181,182) a current controlled by the output signal from the phase shifter (28) and a frequency meter (161) for measuring the frequency of the oscillations of the oscillator thus formed, which frequency is proportional to the magnetic field to be measured, characterized by the fact that the phase shifter (28) is adapted for introducing a constant phase-shift equal to 90° through-out the whole frequency range of the oscillatons, the capacitor forms part of a battery (22) of capacitors and means (26,241,242) are provided for controlling the switching of the capacitors of the battery (22) in response to the value of the frequency measured by the frequency meter (161) so that parasite phase-shifts between the signals picked up and the signals reinjected into the two semi-coils (181,182) always remain less than a threshold.

2. Magnetometer according to claim 1, wherein, at the output of the phase-shifter (28), a controllable gain amplifier (30) is provided connected to a temperature sensor (34) for causing the level of the reinjected signals to vary depending on the temperature.

3. The magnetometer according to one of claims 1 or 2, wherein a sensor (36) is provided for determining the position of the samples (200) with respect to the magnetic field to be measured and a controllable gain amplifier (30) is provided at the output of the phase-shifter (28) which gain is controlled by said position sensor (36), and the VHF generator (14) is power controllable, which power is controlled by said sensor (36).

## Patentansprüche

1. Nuklearmagnetischer Resonanz-Magnetfeldmesser, umfassend zwei Halbspulen (181, 182) zum Abgreifen und zur Rückführung von Kernspinpräzessionssignalen zweier Probekörper (200) aus einem Material, das gyromagnetische Eigenschaften besitzt, welche Probekörper in dem zu messenden Magnetfeld angeordnet sind und durch einen VHF-Generator (141) erregt werden, einen Kondensator (22), der mit den Anschlüssen der zwei Halbspulen (181, 182) verbunden ist, einen Differentialverstärker (121), der mit den Anschlüssen des Kondensators (22) verbunden ist, einen Phasenschieber (28), der mit dem Ausgang des Differentialverstärkers (121) verbunden ist, Mittel (321), um in jede Halbspule (181, 182) einen Strom wiedereinzuspeisen, der durch das Signal am Ausgang des Phasenschiebers (28) gesteuert wird, und einen Frequenzmesser (161) zur Messung der Frequenz der Schwingungen des so gebildeten Oszillators, eine Frequenz, die proportional ist zum zu messenden Magnetfeld, dadurch gekennzeichnet, daß der Phasenschieber (28) vorgesehen ist, um über den gesamten Frequenzbereich der Schwingungen eine konstante Phasenverschiebung von 90° einzustellen, daß der Kondensator zu einer Kondensatorbatterie (22) gehört und daß Mitteln (26, 241, 242) versehen sind, die dazu dienen, in Antwort auf den Wert der mittels des Frequenzmessers (161) gemessenen Frequenz, die Kommutierung der Kondensatoren der Batterie (22) derart zu steuern, daß die parasitären Phasenverschiebungen zwischen den abgegriffenen Signalen und den zu den zwei Halbspulen (181, 182) rückgeführten Signalen immer unterhalb eines Schwellenwerts bleiben.

2. Magnetfeldmesser nach Anspruch 1, bei dem am Ausgang des Phasenschiebers (28) ein Verstärker (30) mit steuerbarer Verstärkung vorgesehen ist, welcher mit einem Temperaturfühler (34) verbunden ist, um den Pegel der rückgeführten Signale in Abhängigkeit von der Temperatur zu verändern.

3. Magnetfeldmesser nach einem der Ansprüche 1 oder 2, bei dem ein Meßfühler (36) zur Bestimmung der Position der Probekörper (200) in bezug auf das zu messende magnetische Feld vorgesehen ist und am Ausgang des Phasenschiebers (28) ein Verstärker (30) mit steuerbarer Verstärkung vorgesehen ist, die durch den genannten Positionsfühler (36) gesteuert wird, und daß der VHF-Generator (14) von steuerbarer Leistung ist, die durch den genannten Meßfühler (36) gesteuert wird.

FIG 1

EP 0 296 005 B1

FIG.2